# EUROPEAN PATENT APPLICATION

(11) **EP 4 203 289 A1**
(43) Date of publication of application: **28.06.2023**
(21) Application number: 20953758.8
(22) Date of filing: 21.09.2020
(51) Int. Cl.: H02M 7/00

(54) **INVERTER, PHOTOVOLTAIC POWER GENERATION SYSTEM AND DEHUMIDIFICATION METHOD**

(71) Applicant: Huawei Digital Power Technologies Co., Ltd., Shenzhen, Guangdong 518043 (CN)
(72) Inventor: LIN, Jianfei, Shenzhen, Guangdong 518129 (CN); ZHU, Jixin, Shenzhen, Guangdong 518129 (CN); PENG, Yu, Shenzhen, Guangdong 518129 (CN)
(74) Representative: Isarpatent
(86) International application number: PCT/CN2020/116418
(87) International publication number: WO 2022/056900

(57) **Abstract**

An inverter (200), a photovoltaic power generation system, and a dehumidification method are disclosed. The inverter (200) includes a ventilation valve (20) and a pneumatic transmission device (30). The ventilation valve (20) is installed on a surface of a cabinet compartment (10) of the inverter (200). A controller (40) and the pneumatic transmission device (30) are located in the cabinet compartment (10). A breathable film (21) is disposed on the ventilation valve (20). The pneumatic transmission device (30) blows air in the cabinet compartment (10) toward the breathable film (21) when the following at least one preset condition is met, so that the air in the cabinet compartment (10) flows out of the cabinet compartment (10) through the breathable film (21). The at least one preset condition includes at least one of or more of the following cases: the inverter (200) is running, humidity in the cabinet compartment (10) is higher than preset humidity, and a temperature in the cabinet compartment (10) is higher than a preset temperature. The pneumatic transmission device (30) is disposed in the cabinet compartment (10) of the inverter (200), and blows high-humidity air in the cabinet compartment (10) toward the breathable film (21) of the ventilation valve (20), so that the high-humidity air in the cabinet compartment (10) flows out of the cabinet compartment (10) through the breathable film (21), to forcibly discharge the air in the cabinet compartment (10), thereby reducing humidity in the cabinet compartment (10) and protecting electrical elements in the inverter (200).

## Description

### TECHNICAL FIELD

This application relates to the field of photovoltaic power generation technologies, and in particular, to an inverter, a photovoltaic power generation system, and a dehumidification method.

### BACKGROUND

At present, propelled by increasingly wide application of photovoltaic power generation, photovoltaic power generation poses increasingly high requirements on inverters. Especially in scenarios such as fishery photovoltaics and ocean power generation, an external environment of an inverter is located in a region with high humidity on a long-term basis.

In an environment with high humidity, when a temperature of an inverter is high, a cabinet compartment of the inverter is in a high-temperature and high-humidity environment, which is similar to "pressure cooker effect". As a result, internal moisture accumulates and absolute humidity in the cabinet compartment is much greater than absolute humidity in an external environment. When a temperature of the external environment decreases, condensation effect is prone to occur in the cabinet compartment of the inverter, which may affect operation of the inverter in a severe case.

In an existing technology for dehumidification through high-temperature heating, dehumidification is achieved through pre-heating and through air exchange based on circadian respiration effect. However, this dehumidification manner is effective in a scenario in which an environment is relatively dry, but has poor dehumidification effect if an external environment is a high-humidity scenario, because humidity is prone to increase due to accumulation effect.

Moreover, a dehumidification method by using a principle similar to that of air conditioning is further available. To be specific, a local condensation technology is used to convert water vapor into liquid, which then flows out. However, by using this dehumidification method, a large amount of power is consumed, and design is complex. Currently, a technology for dehumidification by using desiccant is further available. However, dehumidification by using desiccant is effective only in a low-temperature scenario. When a specific temperature is exceeded, the desiccant basically has no moisture absorption characteristic. In addition, for dehumidification by using desiccant, the desiccant needs to be heated for reuse and a special dehumidification control apparatus is needed, posing a major limitation on application.

### SUMMARY

This application provides an inverter, a photovoltaic power generation system, and a dehumidification method, to effectively dehumidify inside the inverter.

At present, in the field of photovoltaic power generation, many inverters work in a high-humidity and high-temperature environment, for example, especially a high-humidity environment. For a floating photovoltaic power station on the sea, an inverter is in a working environment with high humidity. Excessively high humidity inside a cabinet housing of the inverter is adverse to normal operation of the inverter and causes effect such as damage and corrosion on electrical elements of the inverter. Therefore, dehumidification in a cabinet of the inverter is particularly important. An embodiment of this application provides an inverter. To balance pressure inside and outside a cabinet compartment of the inverter, a ventilation valve is usually disposed on a cabinet housing of the inverter, and the ventilation valve includes a breathable film provided with holes. Therefore, in the inverter provided in this embodiment of this application, a pneumatic transmission device is disposed in the cabinet housing of the inverter. The pneumatic transmission device is located in the cabinet compartment. The pneumatic transmission device is configured to blow air in the cabinet compartment toward the breathable film when the following at least one preset condition is met, so that the air in the cabinet compartment flows out of the cabinet compartment through the breathable film. The at least one preset condition includes at least one of or more of the following cases: the inverter is running, humidity in the cabinet compartment is higher than preset humidity, and a temperature in the cabinet compartment is higher than a preset temperature. In other words, duration of working of the pneumatic transmission device is not specifically limited in this embodiment of this application. The pneumatic transmission device may run continuously, or may run when a preset condition is met, to complete dehumidification in the cabinet compartment of the inverter.

The pneumatic transmission device is disposed in the cabinet compartment of the inverter. When dehumidification needs to be performed in the cabinet compartment, the pneumatic transmission device starts to work, and blows high-humidity air in the cabinet compartment toward the breathable film of the ventilation valve, so that the high-humidity air in the cabinet compartment flows out of the cabinet compartment through the breathable film, to forcibly discharge the air in the cabinet compartment, thereby reducing humidity in the cabinet compartment and protecting electrical elements of the inverter.

Preferably, a start time of the pneumatic transmission device is not specifically limited in this embodiment of this application. For example, the inverter further includes a controller, and the controller is used to implement start/stop control on the pneumatic transmission device. The controller is configured to: when the at least one preset condition is met, control the pneumatic transmission device to work, so that the air in the cabinet compartment flows out of the cabinet compartment through the breathable film. The pneumatic transmission device is specifically configured to blow the air in the cabinet compartment toward the breathable film in a direction perpendicular to a plane of the breathable film.

Preferably, a specific implementation type of the pneumatic transmission device is not specifically limited in this application. For example, the pneumatic transmission device is a fan or a pneumatic pump, and may be specifically selected and disposed based on a space size of a cabinet of the inverter.

Preferably, to prolong a service life of the pneumatic transmission device and prevent the pneumatic transmission device from processing work for a long time, the pneumatic transmission device may be controlled to work intermittently. For example, the controller is further configured to: when a working time of the pneumatic transmission device is longer than a preset time period, control the pneumatic transmission device to stop working.

Preferably, the controller of the inverter may control the pneumatic transmission device based on humidity, and is specifically configured to: when the inverter is running and the humidity in the cabinet compartment is higher than the preset humidity, control the pneumatic transmission device to work.

Preferably, humidity is also high when a temperature is high. Therefore, the controller of the inverter may control the pneumatic transmission device based on a temperature. The controller is specifically configured to: when the inverter is running and the temperature in the cabinet compartment is higher than the preset temperature, control the pneumatic transmission device to work.

Preferably, to more accurately control operation of the pneumatic transmission device and prolong a service life of the pneumatic transmission device, the controller may control the pneumatic transmission device to work when the inverter is running, the temperature in the cabinet compartment is higher than the preset temperature, and the humidity in the cabinet is higher than the preset humidity.

Preferably, to more accurately control operation of the pneumatic transmission device and prolong a service life of the pneumatic transmission device, when the inverter is not running, the controller may also control the pneumatic transmission device based on a humidity condition. Specifically, when the inverter is not running and the humidity in the cabinet compartment is higher than preset humidity, the controller controls the pneumatic transmission device to work.

Preferably, to more accurately control operation of the pneumatic transmission device and prolong a service life of the pneumatic transmission device, the controller is specifically configured to: when the inverter is not running and the temperature in the cabinet compartment is higher than the preset temperature, control the pneumatic transmission device to work.

Preferably, to more accurately control operation of the pneumatic transmission device and prolong a service life of the pneumatic transmission device, the controller is specifically configured to: when the inverter is not running, the temperature in the compartment is higher than the preset temperature, and the humidity in the compartment is higher than the preset humidity, control the pneumatic transmission device to work.

Preferably, to dehumidify to the greatest extent, the controller may control the pneumatic transmission device to work when the inverter is running. In other words, dehumidification is performed provided that the inverter is running.

An embodiment of this application further provides a photovoltaic power generation system, which includes the inverter described in the foregoing embodiment and further includes a photovoltaic array. An input end of the inverter is connected to the photovoltaic array. The inverter is configured to convert a direct current of the photovoltaic array into an alternating current for output.

Especially for a floating photovoltaic power station on the sea, an inverter of a photovoltaic power generation system is constantly in a high-humidity environment. To protect electrical elements in a cabinet compartment of the inverter, dehumidification needs to be performed in the cabinet compartment of the inverter. A pneumatic transmission device is disposed in the cabinet compartment of the inverter. The pneumatic transmission device is configured to blow high-humidity air toward a breathable film of a ventilation valve, to forcibly make the high-humidity air in the cabinet compartment to flow out, thereby achieving dehumidification. A type of the inverter is not specifically limited in this embodiment of this application. The inverter may be a single-stage inverter, or may be a two-stage inverter. A specific application scenario of the inverter is not limited in this application. The application scenario may be a floating power station, or may be another photovoltaic power generation system.

An embodiment of this application further provides a dehumidification method for an inverter. The inverter includes a ventilation valve and a pneumatic transmission device. The ventilation valve is installed on a surface of a cabinet compartment of the inverter. The pneumatic transmission device is located in the cabinet compartment. A breathable film is disposed on the ventilation valve. The method includes: when the following at least one preset condition is met, controlling the pneumatic transmission device to blow air in the cabinet compartment toward the breathable film, so that the air in the cabinet compartment flows out of the cabinet compartment through the breathable film, where the at least one preset condition includes at least one of or more of the following cases: the inverter is running, humidity in the cabinet compartment is higher than preset humidity, and a temperature in the cabinet compartment is higher than a preset temperature.

Preferably, to efficiently dehumidify to the greatest extent, a position and an air exhaust direction of the pneumatic transmission device may be set. For example, a shorter distance between the pneumatic transmission device and the breathable film means stronger air exhaust force. In addition, if the air exhaust direction is perpendicular to a plane in which the breathable film is located, more air is ventilated, so that air is propelled to flow out of the cabinet compartment to the greatest extent. The blowing air in the cabinet compartment toward the breathable film specifically includes: blowing the air in the cabinet compartment toward the breathable film in a direction perpendicular to the plane of the breathable film.

Preferably, to prolong a service life of the pneumatic transmission device, the pneumatic transmission device may be controlled to work intermittently instead of working continuously. The pneumatic transmission device is a fan or a pneumatic pump. The method further includes: when a working time of the pneumatic transmission device is longer than a preset time period, controlling the pneumatic transmission device to stop working.

Preferably, controlling the pneumatic transmission device to work specifically includes: when the inverter is running and the humidity in the cabinet compartment is higher than the preset humidity, controlling the pneumatic transmission device to work.

Preferably, controlling the pneumatic transmission device to work specifically includes: when the inverter is running and the temperature in the cabinet compartment is higher than the preset temperature, controlling the pneumatic transmission device to work.

Preferably, controlling the pneumatic transmission device to work specifically includes: when the inverter is running, the temperature in the cabinet compartment is higher than the preset temperature, and the humidity in the cabinet is higher than the preset humidity, controlling the pneumatic transmission device to work.

Preferably, controlling the pneumatic transmission device to work specifically includes: when the inverter is not running and the humidity in the cabinet compartment is higher than the preset humidity, controlling the pneumatic transmission device to work.

Preferably, controlling the pneumatic transmission device to work specifically includes: when the inverter is not running and the temperature in the cabinet compartment is higher than the preset temperature, controlling the pneumatic transmission device to work.

Preferably, controlling the pneumatic transmission device to work specifically includes: when the inverter is not running, the temperature in the compartment is higher than the preset temperature, and the humidity in the compartment is higher than the preset humidity, controlling the pneumatic transmission device to work.

Preferably, controlling the pneumatic transmission device to work specifically includes: when the inverter is running, controlling the pneumatic transmission device to work.

It can be learned from the foregoing technical solutions that the embodiments of this application have the following advantages:

The pneumatic transmission device is disposed in the cabinet compartment of the inverter. When dehumidification needs to be performed in the cabinet compartment, the pneumatic transmission device starts to work, and blows high-humidity air in the cabinet compartment toward the breathable film of the ventilation valve, so that the high-humidity air in the cabinet compartment flows out of the cabinet compartment through the breathable film, to forcibly discharge the air in the cabinet compartment, thereby reducing humidity in the cabinet compartment and protecting electrical elements of the inverter. Specifically, the pneumatic transmission device may be started to work when the inverter is running, to perform dehumidification inside the cabinet compartment. Alternatively, when the inverter is running and the humidity in the cabinet compartment is higher than the preset humidity, the pneumatic transmission device may be controlled to run, or when the inverter is running and the temperature in the cabinet compartment is higher than the preset temperature, the pneumatic transmission device may be controlled to run. In addition, when the inverter is not running, but the temperature or humidity in the cabinet compartment meets a corresponding trigger condition, the pneumatic transmission device may also be controlled to start and perform dehumidification; or when both the temperature and the humidity meet a corresponding trigger condition, the pneumatic transmission device may be started to perform dehumidification.

### BRIEF DESCRIPTION OF DRAWINGS

FIG. 1 is a schematic diagram of a photovoltaic power generation system according to an embodiment of this application;
FIG. 2 is a schematic diagram of an inverter according to an embodiment of this application;
FIG. 3 is a schematic diagram of another inverter according to an embodiment of this application;
FIG. 4A is a schematic diagram of an inverter including a controller according to an embodiment of this application;
FIG. 4B is a schematic diagram of still another inverter according to an embodiment of this application;
FIG. 5 is a flowchart of a method for dehumidification when an inverter is running according to an embodiment of this application;
FIG. 6 is a flowchart of a method for dehumidification based on humidity when an inverter is running according to an embodiment of this application;
FIG. 7 is a flowchart of a method for dehumidification based on a temperature when an inverter is running according to an embodiment of this application;
FIG. 8 is a flowchart of a method for dehumidification based on a temperature and humidity when an inverter is running according to an embodiment of this application;
FIG. 9 is a flowchart of a method for dehumidification based on humidity when an inverter is not running according to an embodiment of this application;
FIG. 10 is a flowchart of a method for dehumidification based on a temperature when an inverter is not running according to an embodiment of this application; and
FIG. 11 is a flowchart of a method for dehumidification based on a temperature and humidity when an inverter is not running according to an embodiment of this application.

### DESCRIPTION OF EMBODIMENTS

To make persons skilled in the art better understand technical solutions provided in embodiments of this application, the following describes an application scenario of the technical solutions provided in the embodiments of this application with reference to the accompanying drawings.

As an example for description, an inverter is applied to a photovoltaic power generation system. In addition, the inverter may also be applied to another field. This is not specifically limited in embodiments of this application. In any application scenario, when humidity in an inverter is high, dehumidification may be performed in a cabinet compartment of the inverter by using a technical solution provided in an embodiment of this application.

For example, when an inverter is applied to a photovoltaic power generation system, currently, to effectively use sunlight on the sea for photovoltaic power generation, many floating photovoltaic power stations emerge. The floating photovoltaic power stations are located in an environment with high humidity for a long time. Therefore, dehumidification inside the inverter is especially important. Otherwise, electrical elements in a cabinet compartment of the inverter may fail during long-term operation, affecting normal operation of the photovoltaic power generation system.

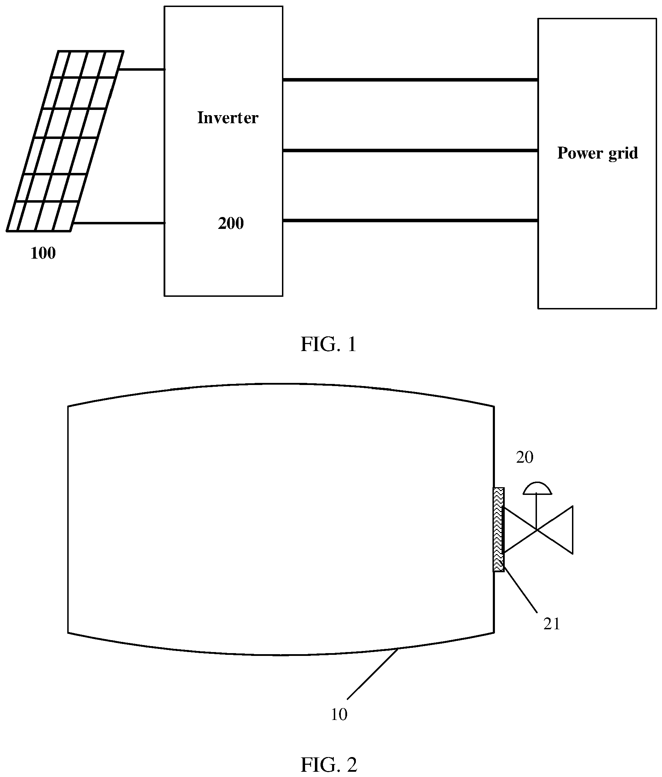

FIG. 1 is a schematic diagram of a photovoltaic power generation system according to an embodiment of this application.

The photovoltaic power generation system provided in this embodiment of this application includes a photovoltaic array 100 and an inverter 200.

An input end of the inverter 200 is connected to the photovoltaic array 100.

The inverter 200 converts a direct current of the photovoltaic array 100 into an alternating current for output, for example, feeding back the alternating current to an alternating current power grid or providing the alternating current to an alternating current load.

A specific type of the photovoltaic array 100 is not specifically limited in this embodiment of this application. For example, to improve a power supply capability, the photovoltaic array 100 includes a plurality of photovoltaic strings connected in series and parallel.

A specific type of the inverter 200 is not specifically limited in this embodiment of this application. The inverter 200 may be a single-stage inverter, which includes only an inverter circuit. In addition, the inverter may alternatively be a two-stage inverter, which includes a direct current/direct current (DC/DC) circuit and an inverter circuit, where the DC/DC circuit implements voltage boosting, voltage bucking, or voltage boosting and voltage bucking.

In addition, to improve power, output ends of a plurality of DC/DC circuits may be connected in parallel to an input end of the inverter circuit, and each DC/DC circuit is connected to one photovoltaic array.

In addition, if the inverter includes only the inverter circuit, a combiner box may be further included between the inverter 200 and the photovoltaic array 100. The combiner box may include a DC/DC circuit.

### Inverter Embodiment 1

Generally, a cabinet compartment of an inverter must meet the IP65 requirement. To be specific, the cabinet compartment must be dustproof and waterproof, and allows only gas to pass through. For an inverter provided in this embodiment of this application, to balance pressure inside and outside a cabinet compartment of the inverter, a ventilation valve is disposed on a housing of the cabinet compartment.

FIG. 2 is a schematic diagram of an inverter according to this embodiment of this application.

A ventilation valve 20 is disposed on a housing of a cabinet compartment 10 of the inverter, and the ventilation valve includes a breathable film 21.

Generally, a plurality of air vents are provided on the ventilation valve 20, and the breathable film may complete air exchange between inside and outside portions of the cabinet compartment 10 by using the air vents. Therefore, the inverter uses the ventilation valve 20 to balance pressure inside and outside the cabinet compartment 10.

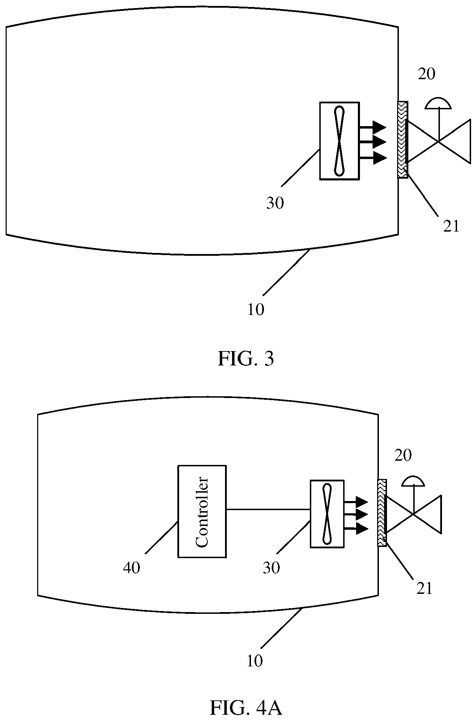

FIG. 3 is a schematic diagram of another inverter according to this embodiment of this application.

The inverter provided in this embodiment includes a ventilation valve 20 and a pneumatic transmission device 30.

The ventilation valve 20 is installed on a surface of a cabinet compartment of the inverter, and a breathable film 21 is disposed on the ventilation valve 20.

The pneumatic transmission device 30 is located in the cabinet compartment 10.

The pneumatic transmission device 30 is configured to blow air in the cabinet compartment to the breathable film when the following at least one preset condition is met, so that the air in the cabinet compartment flows out of the cabinet compartment through the breathable film, where the at least one preset condition includes at least one of or more of the following cases: the inverter is running, humidity in the cabinet compartment is higher than preset humidity, and a temperature in the cabinet compartment is higher than a preset temperature. In other words, a condition for starting the pneumatic transmission device 30 to work may be that one of the at least one preset condition is met, may be that two of the at least one preset condition are met, or may be that all three of the at least one preset condition are met, which may be specifically set based on an actual requirement.

The pneumatic transmission device 30 may be started autonomously, or may be started under control of a controller, in which case the controller controls the pneumatic transmission device 30 to start and stop working. The following provides description with reference to FIG. 4A. FIG. 4A is a schematic diagram of an inverter including a controller according to this embodiment of this application.

The inverter provided in this embodiment further includes a controller 40, and the controller 40 is also located in the cabinet compartment 10 of the inverter.

The controller 40 is configured to: when the following at least one preset condition is met, control the pneumatic transmission device 30 to start to work, where the at least one preset condition includes at least one of or more of the following cases: the inverter is running, humidity in the cabinet compartment 10 is higher than preset humidity, and a temperature in the cabinet compartment is greater than a preset temperature. In other words, the preset condition is at least one of the following cases: the inverter is running, the humidity in the cabinet compartment is higher than the preset humidity, or the temperature in the cabinet compartment is higher than the preset temperature.

A specific position of the ventilation valve 20 in the cabinet compartment 10 is not specifically limited in this embodiment of this application. For example, the ventilation valve 20 may be disposed on a side surface of the cabinet compartment 10, or may be disposed on a bottom surface of the cabinet compartment 10.

To enhance flow of gas and achieve better dehumidification, the pneumatic transmission device 30 may be disposed directly opposite the breathable film 21, so that when the pneumatic transmission device 30 works, the air in the cabinet compartment 10 is blown to the breathable film 21 in a direction perpendicular to a plane of the breathable film 21. Certainly, a flow direction of the air may also be blown to the breathable film 21 at an angle of less than 90 degrees to the breathable film 21, which is not specifically limited in this embodiment.

An implementation of the pneumatic transmission device 30 is not specifically limited in this embodiment of this application. For example, the pneumatic transmission device 30 may be a fan or a pneumatic pump.

For example, the pneumatic transmission device 30 is a fan. A size of the fan may be set based on a size of the breathable film 21, provided that a diameter of the fan is greater than a diameter of the breathable film 21, which is conducive to blowing high-humidity air out of the cabinet compartment 10 with maximum efficiency.

A position of the fan may be set based on an actual requirement. For example, the fan may be disposed near the breathable film, to facilitate air flow.

The controller 40 may be directly implemented by using a controller of the inverter, or another controller may be separately disposed as required. This is not specifically limited in this embodiment of this application.

Specifically, the controller 40 may control a rotation speed of the fan based on an environment condition in the cabinet compartment 10. To be specific, the rotation speed of the fan may be changed by changing an electrical signal sent to the fan. For example, assuming that the fan is controlled based on the humidity in the cabinet compartment 10, when the humidity in the cabinet compartment 10 is greater than first preset humidity, the fan is controlled to start and work at a first rotation speed; or when the humidity in the cabinet compartment 10 is greater than second preset humidity, the fan is controlled to work at a second rotation speed, where the second rotation speed is higher than the second rotation speed, and the first preset humidity is higher than the first preset humidity.

The foregoing is merely an example illustrating that the fan can work at different rotation speed levels, and only two rotation speeds of different levels are used as examples. Specifically, preset temperatures of more levels and corresponding rotation speeds of more levels may be set as required, and details are not described herein, provided that a rotation speed increases as humidity increases. Certainly, alternatively, the fan may continuously run at a fixed rotation speed, which is not specifically limited in this embodiment.

For another example, assuming that the fan is controlled based on the temperature in the cabinet compartment 10, when the temperature in the cabinet compartment 10 is higher than a first preset temperature, the fan is controlled to start and work at a third rotation speed. When the temperature in the cabinet compartment 10 is higher than a second preset temperature, the fan is controlled to work at a fourth rotation speed. The fourth rotation speed is higher than the third rotation speed, and the first preset temperature is higher than the first preset temperature.

When the inverter meets at least one of the foregoing preset adjustment, the pneumatic transmission device starts to work and blows air to the breathable film, to form high-speed air contact near the breathable film, so that high-humidity molecules in the cabinet compartment overcome resistance and flow out of the cabinet compartment. The high-humidity molecules maintain specific atmospheric pressure on an inner side of the breathable film. As a result, the internal highly concentrated high-humidity molecules spread to an outside of the breathable film under specific motion stress, and internal humidity decreases at a specific rate and finally decreases to humidity close to that of an external environment. In this embodiment, the pneumatic transmission device is used to forcibly diffuse air in the cabinet compartment. High-humidity air that flows out of the cabinet compartment is more than high-humidity air that freely diffuses into the cabinet compartment. After a specific period of dehumidification, absolute humidity in the cabinet compartment is close to absolute humidity of the external environment, thereby achieving dehumidification inside the cabinet compartment. For example, a photovoltaic power station is deployed in a damp environment, for example, on the sea. If dehumidification is not performed in a cabinet compartment of an inverter in time, condensation is prone to occur in the cabinet compartment of the inverter when a temperature of an external environment decreases. A measure taken in this embodiment of this application is to perform forced dehumidification by using a pneumatic transmission device, so that condensation in the cabinet compartment of the inverter can be reduced or avoided.

### Inverter Embodiment 2

The following describes, in detail with reference to the accompanying drawings, various implementations in which a pneumatic transmission device is triggered to work.

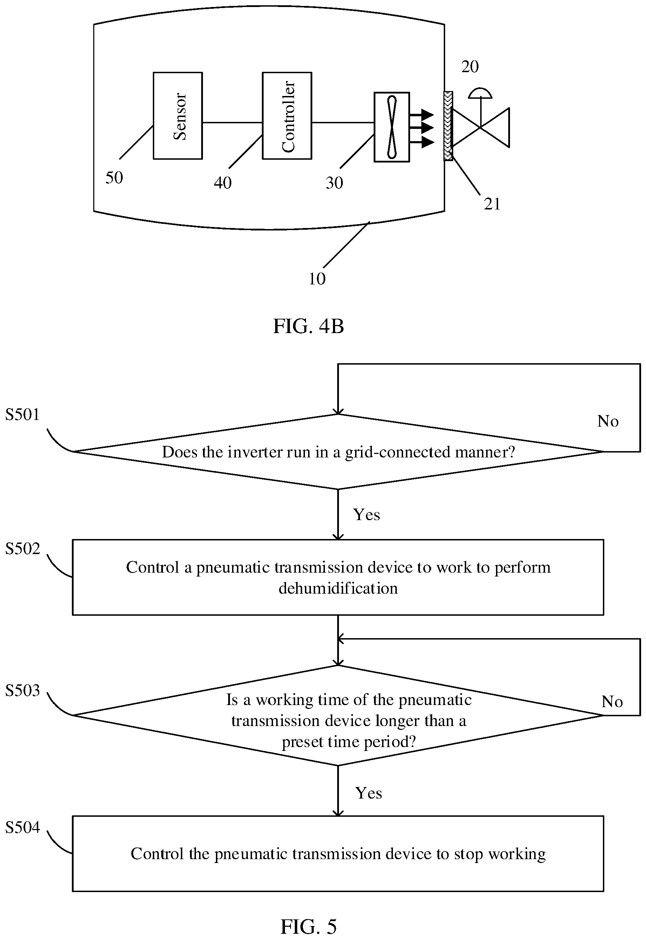

FIG. 4B is a schematic diagram of still another inverter according to this embodiment of this application.

In this embodiment, a sensor 50 may be disposed in a cabinet compartment 10 of the inverter. The sensor 50 may be a temperature sensor, may be a humidity sensor, or may be a temperature and humidity sensor.

To prolong a service life of the pneumatic transmission device, when the pneumatic transmission device has been working continuously for a long time, the pneumatic transmission device may be controlled to stop working and rest for a period of time. Then, if at least one preset condition is met, the pneumatic transmission device may be controlled to continue to work. Specifically, when a controller controls the pneumatic transmission device to start working, counting of a working time of the pneumatic transmission device starts. When the working time of the pneumatic transmission device is longer than a preset time period, the controller controls the pneumatic transmission device to stop working.

A preset condition for triggering the pneumatic transmission device includes at least one of the following three conditions and a combination of two or three of the following three conditions:
A: The inverter is running.
B: Humidity in the cabinet compartment 10 is higher than preset humidity.
C: A temperature in the cabinet compartment is higher than a preset temperature.

Combinations of A, B, and C include AB, AC, ABC, and BC.

The following describes an implementation corresponding to A.

The controller is specifically configured to: when the inverter is running, control the pneumatic transmission device to work, for example, control a fan to start and perform dehumidification.

Generally, when the inverter is running, the temperature in the cabinet compartment increases, the humidity increases accordingly, and pressure in the cabinet compartment increases. In this case, the pneumatic transmission device can be used for dehumidification.

That the inverter is running means that the inverter starts to work. The controller may learn information about whether the inverter is working. For example, the inverter performs grid-connected power generation during operation. In other words, the inverter runs in a grid-connected manner. In grid-connected running, whether the inverter runs in a grid-connected manner may be determined based on whether a relay at an output end of the inverter is closed.

In this dehumidification manner, the gas transmission device is started to perform dehumidification inside the cabinet compartment of the inverter provided that the inverter is running, to better protect electrical elements inside the inverter from being in a high-humidity environment.

The following describes an implementation corresponding to AB.

The controller is specifically configured to: when the inverter is running and the humidity in the cabinet compartment is higher than the preset humidity, control the pneumatic transmission device to work.

The humidity in the cabinet compartment may be specifically obtained by setting a humidity sensor in the cabinet compartment. The humidity sensor sends measured humidity to the controller. The controller determines, based on the received humidity, whether the humidity is higher than the preset humidity. When the received humidity is higher than the preset humidity, the controller controls a fan to start and perform dehumidification. When the humidity is lower than or equal to the preset humidity, it indicates that the humidity has decreased to a safe range, and the controller controls the fan to stop running.

In this dehumidification manner, when the inverter is running and the humidity is higher than the preset humidity, the fan is controlled to run. In other words, the fan is controlled to run only when necessary, thereby effectively controlling a running time of the fan and prolonging a service life of the fan.

The following describes an implementation corresponding to AC.

The controller is specifically configured to: when the inverter is running and the temperature in the cabinet compartment is higher than the preset temperature, control the pneumatic transmission device to work.

Generally, a temperature and humidity are closely related. When the temperature rises, the humidity generally rises accordingly. Therefore, whether to trigger the pneumatic transmission device to work may also be determined based on the temperature.

The temperature in the cabinet compartment may be specifically obtained by setting a temperature sensor in the cabinet compartment. The temperature sensor sends a measured temperature to the controller. The controller determines, based on the received temperature, whether the temperature is higher than the preset temperature. When the received temperature is higher than the preset temperature, the controller controls a fan to start and perform dehumidification. When the temperature is lower than or equal to the preset temperature, it indicates that the temperature has decreased to a safe range. The humidity also decreases, and the controller controls the fan to stop running.

In this dehumidification manner, when the inverter is running and the temperature is higher than the preset temperature, the fan is controlled to run. The fan is triggered to run based on a temperature condition, which may also prolong a service life of the fan.

The following describes an implementation corresponding to ABC.

The controller is specifically configured to: when the inverter is running, the temperature in the cabinet compartment is higher than the preset temperature, and the humidity in the cabinet is higher than the preset humidity, control the pneumatic transmission device to work.

In this implementation of the solution, the pneumatic transmission device is started to work to perform dehumidification only when both the temperature and the humidity in the cabinet compartment meet the preset condition.

Specifically, a temperature and humidity sensor may be set in the cabinet compartment. The temperature and humidity sensor can measure both a temperature in the cabinet compartment and humidity in the cabinet compartment, and send the measured humidity and temperature to the controller. When determining that the temperature is higher than the preset temperature and the humidity is higher than the preset humidity, the controller starts a fan to work. The fan is controlled to stop working only when the humidity is less than or equal to the preset humidity and the temperature is less than or equal to the preset temperature.

In this dehumidification manner, the fan is controlled to run only when the inverter is running and both the temperature and the humidity meet the corresponding preset conditions. In this way, dehumidification can be accurately and effectively performed in the cabinet compartment, and a service life of the fan is prolonged.

The foregoing describes a corresponding dehumidification working status when the inverter is running. The following describes a dehumidification working status when the inverter is not running. Generally, a photovoltaic array does not output a direct current at night when there is no sunlight, and therefore an inverter may not work. However, the inverter is still located in a high-humidity environment at night, and the high-humidity environment is prone to affect the inverter. Therefore, dehumidification needs to be performed inside the inverter to protect the inverter.

The following describes an implementation corresponding to B.

The controller is specifically configured to: when the inverter is not running and the humidity in the cabinet compartment is higher than the preset humidity, control the pneumatic transmission device to work.

It should be noted that when the inverter is not running, the controller may be running.

The humidity in the cabinet compartment may be specifically obtained by setting a humidity sensor in the cabinet compartment. The humidity sensor sends measured humidity to the controller. The controller determines, based on the received humidity, whether the humidity is higher than the preset humidity. When the received humidity is higher than the preset humidity, the controller controls a fan to start and perform dehumidification. When the humidity is lower than or equal to the preset humidity, it indicates that the humidity has decreased to a safe range, and the controller controls the fan to stop running.

The following describes an implementation corresponding to C.

The controller is specifically configured to: when the inverter is not running and the temperature in the cabinet compartment is higher than the preset temperature, control the pneumatic transmission device to work.

Generally, a temperature and humidity are closely related. When the temperature rises, the humidity generally rises accordingly. Therefore, whether to trigger the pneumatic transmission device to work may also be determined based on the temperature.

The temperature in the cabinet compartment may be specifically obtained by setting a temperature sensor in the cabinet compartment. The temperature sensor sends a measured temperature to the controller. The controller determines, based on the received temperature, whether the temperature is higher than the preset temperature. When the received temperature is higher than the preset temperature, the controller controls a fan to start and perform dehumidification. When the temperature is lower than or equal to the preset temperature, it indicates that the temperature has decreased to a safe range. The humidity also decreases, and the controller controls the fan to stop running.

The following describes an implementation corresponding to BC.

The controller is specifically configured to: when the inverter is not running, the temperature in the compartment is higher than the preset temperature, and the humidity in the compartment is higher than the preset humidity, control the pneumatic transmission device to work.

Specifically, a temperature and humidity sensor may be set in the cabinet compartment. The temperature and humidity sensor can measure both a temperature in the cabinet compartment and humidity in the cabinet compartment, and send the measured humidity and temperature to the controller. When determining that the temperature is higher than the preset temperature and the humidity is higher than the preset humidity, the controller starts the fan to work. The fan is controlled to stop working only when the humidity is less than or equal to the preset humidity and the temperature is less than or equal to the preset temperature.

In all the dehumidification working modes described above, control over a working time may be accompanied during operation. To be specific, if the working time of the gas transmission device exceeds the preset time period, the gas transmission device is controlled to stop working, so as to prolong the service life of the gas transmission device.

### Embodiment of Photovoltaic Power Generation System

Based on the inverter provided in the foregoing embodiments, this embodiment of this application further provides a photovoltaic power generation system. Still referring to FIG. 1, the inverter in FIG. 1 is the inverter provided in any one of the foregoing embodiments. The photovoltaic power generation system further includes a photovoltaic array 100.

An input end of an inverter 200 is connected to the photovoltaic array 100.

The inverter 200 is configured to convert a direct current of the photovoltaic array 100 into an alternating current, and feed back the alternating current to an alternating current power grid.

A specific implementation of the inverter 200 is not specifically limited in this embodiment. For example, the inverter 200 may be a one-stage inverter that includes only an inverter circuit, or may be a two-stage inverter that includes both a direct current/direct current DC/DC conversion circuit and an inverter circuit.

The inverter in the photovoltaic power generation system can effectively dehumidify an inside of a cabinet compartment of the inverter. Therefore, the inverter can effectively run in a high-humidity environment. It is ensured that electrical elements in the cabinet compartment of the inverter are not located in a high-humidity environment for a long time. This protects the components in the cabinet compartment of the inverter, so that the inverter can run properly, thereby ensuring normal operation of the entire photovoltaic power generation system.

### Method Embodiment 1

Based on the inverter and the photovoltaic power generation system provided in the foregoing embodiments, this embodiment of this application further provides a dehumidification method for an inverter. Detailed descriptions are provided below with reference to accompanying drawings.

The dehumidification method for an inverter provided in this embodiment is applied to dehumidification inside a cabinet compartment of the inverter. The inverter includes a ventilation valve and a pneumatic transmission device. The ventilation valve is installed on a surface of the cabinet compartment of the inverter. The pneumatic transmission device is located in the cabinet compartment of the inverter. To balance pressure inside and outside the cabinet compartment of the inverter, a breathable film is disposed on the ventilation valve.

The method includes:
when the following at least one preset condition is met, controlling the pneumatic transmission device to blow air in the cabinet compartment toward the breathable film, so that the air in the cabinet compartment flows out of the cabinet compartment of the inverter through the breathable film. To be specific, air with high humidity in the cabinet compartment is forcibly discharged, to accelerate air circulation between inside and outside portions of the cabinet compartment and increase a volume of air exchanged between the inside and the outside of the cabinet compartment, thereby quickly reducing humidity inside the cabinet compartment.

The at least one preset condition includes at least one or more of the following cases: the inverter is running, humidity in the cabinet compartment is higher than the preset humidity, and a temperature in the cabinet compartment is higher than a preset temperature.

The pneumatic transmission device may be a fan or a pneumatic pump.

To enhance a dehumidification effect and accelerate air flow, specifically, the blowing air in the cabinet compartment toward the breathable film specifically includes:
controlling the air in the cabinet compartment to be blown toward the breathable film in a direction perpendicular to a plane of the breathable film. To be specific, if a flow direction of the air in the cabinet compartment is perpendicular to the plane of the breathable film, maximum flow and pressure can be pressed to the breathable film. Holes are provided on the breathable film. Therefore, the vertically blown air is blown out of the cabinet compartment to the greatest extent.

The following separately describes various trigger conditions of the pneumatic transmission device. In addition, to protect the pneumatic transmission device and prolong a service life of the pneumatic transmission device, control over a working time of the pneumatic transmission device is added in the following method embodiments. Certainly, the pneumatic transmission device may alternatively run continuously when humidity is high.

FIG. 5 is a flowchart of a method for dehumidification when an inverter is running according to this embodiment of this application.

In this embodiment, the only trigger condition is that the inverter is running.

S501: Determine whether the inverter is running in a grid-connected manner; and if yes, perform S502; otherwise, continue to perform S501.

S502. Control the pneumatic transmission device to work to perform dehumidification.

S503: Determine whether the working time of the pneumatic transmission device is longer than a preset time period; and if yes, perform S504; otherwise, continue to perform S503.

S504: Control the pneumatic transmission device to stop working. When the gas transmission device is a fan, the fan is shut down.

Generally, when the inverter is running, the temperature in the cabinet compartment increases, the humidity increases accordingly, and pressure in the cabinet compartment increases. In this case, the pneumatic transmission device can be used for dehumidification.

That the inverter is running means that the inverter starts to work. A controller may learn information about whether the inverter is working. For example, the inverter performs grid-connected power generation during operation. In other words, the inverter runs in a grid-connected manner. In grid-connected running, whether the inverter runs in a grid-connected manner may be determined based on whether a relay at an output end of the inverter is closed.

In this dehumidification manner, the gas transmission device is started to perform dehumidification inside the cabinet compartment of the inverter provided that the inverter is running, to better protect electrical elements inside the inverter from being in a high-humidity environment.

The following description is provided by using an example in which humidity is used as a trigger condition when the inverter is running.

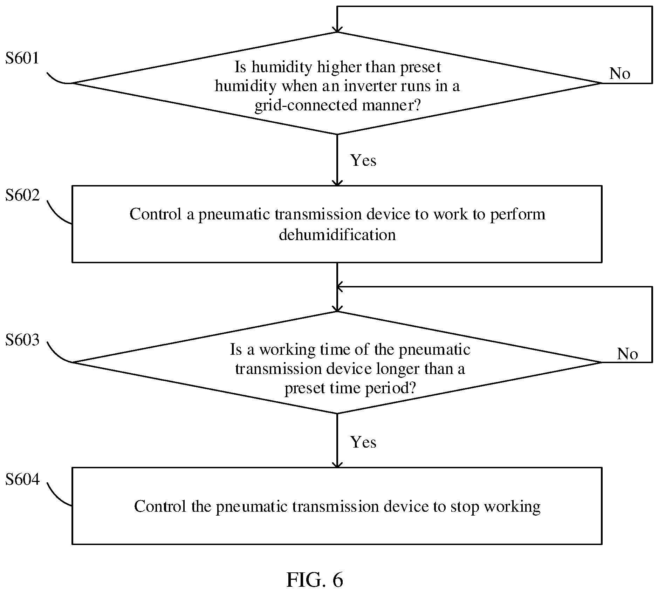

FIG. 6 is a flowchart of a humidity-based dehumidification method according to this embodiment of this application.

S601: When the inverter is running in a grid-connected manner, determine whether the humidity in the cabinet compartment is higher than the preset humidity; and if yes, perform S602; otherwise, continue to perform S601.

S602: Control the pneumatic transmission device to work and start dehumidification.

S603: Determine whether the working time of the pneumatic transmission device is longer than a preset time period; if yes, perform S604; otherwise, continue to perform S604.

S604: Control the pneumatic transmission device to stop working.

In this dehumidification manner, when the inverter is running and the humidity is higher than the preset humidity, a fan is controlled to run. In other words, the fan is controlled to run only when necessary, thereby effectively controlling a running time of the fan and prolonging a service life of the fan.

The following description is provided by using an example in which a temperature is used as a trigger condition when the inverter is running.

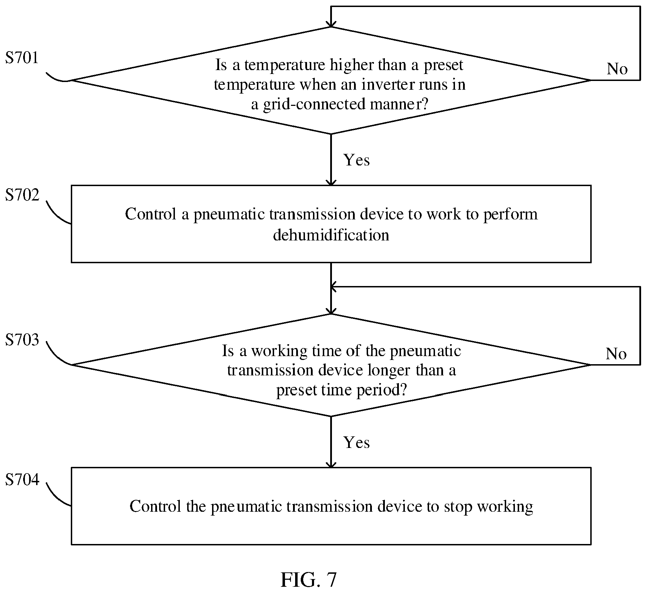

FIG. 7 is a flowchart of a temperature-based dehumidification method according to this embodiment of this application.

Generally, a temperature and humidity are closely related. When the temperature rises, the humidity generally rises accordingly. Therefore, whether to trigger the pneumatic transmission device to work may also be determined based on the temperature.

S701: When the inverter is running in a grid-connected manner, determine whether the temperature in the cabinet compartment is higher than the preset temperature; and if yes, perform S702; otherwise, continue to perform S701.

S702: Control the pneumatic transmission device to work and start dehumidification.

S703: Determine whether the working time of the pneumatic transmission device is longer than a preset time period; if yes, perform S704; otherwise, continue to perform S704.

S704: Control the pneumatic transmission device to stop working.

In this dehumidification manner, when the inverter is running and the temperature is higher than the preset temperature, a fan is controlled to run. The fan is triggered to run based on a temperature condition, which may also prolong a service life of the fan.

The following description is provided by using an example in which both a temperature and humidity are used as trigger conditions when the inverter is running.

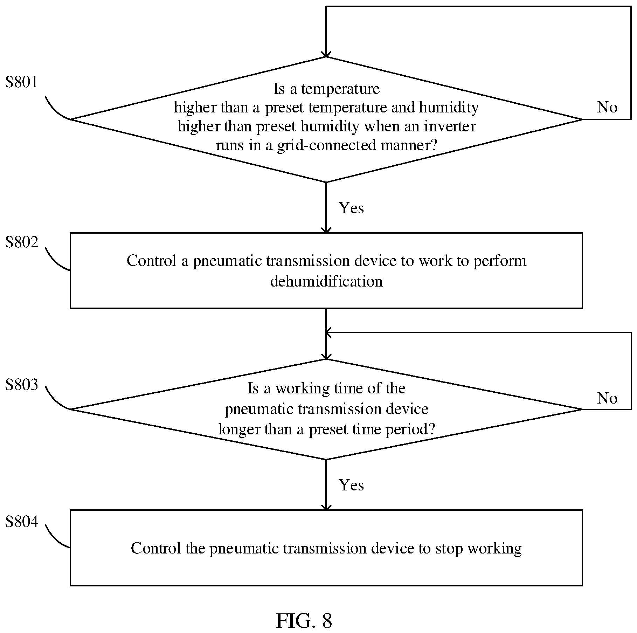

FIG. 8 is a flowchart of a temperature- and humidity-based dehumidification method according to this embodiment of this application.

S801: When the inverter is running in a grid-connected manner, determine whether the temperature in the cabinet compartment is higher than the preset temperature and the humidity in the cabinet compartment is higher than the preset humidity; and if yes, perform S802; otherwise, continue to perform S801. In other words, the pneumatic transmission device is started to work only when the humidity is higher than the preset humidity and the temperature is higher than the preset temperature.

S802: Control the pneumatic transmission device to work and start dehumidification.

S803: Determine whether the working time of the pneumatic transmission device is longer than a preset time period; if yes, perform S804; otherwise, continue to perform S804.

S804: Control the pneumatic transmission device to stop working.

Specifically, a temperature and humidity sensor may be set in the cabinet compartment. The temperature and humidity sensor can measure both a temperature in the cabinet compartment and humidity in the cabinet compartment, and send the measured humidity and temperature to a controller. When determining that the temperature is higher than the preset temperature and the humidity is higher than the preset humidity, the controller starts a fan to work. The fan is controlled to stop working only when the humidity is less than or equal to the preset humidity and the temperature is less than or equal to the preset temperature.

In this dehumidification manner, the fan is controlled to run only when the inverter is running and both the temperature and the humidity meet the corresponding preset conditions. In this way, dehumidification can be accurately and effectively performed in the cabinet compartment, and a service life of the fan is prolonged.

FIG. 5 to FIG. 8 describe a working process of controlling the pneumatic transmission device to perform dehumidification when the inverter is running. The following describes a working process of controlling the pneumatic transmission device to perform dehumidification when the inverter is not running.

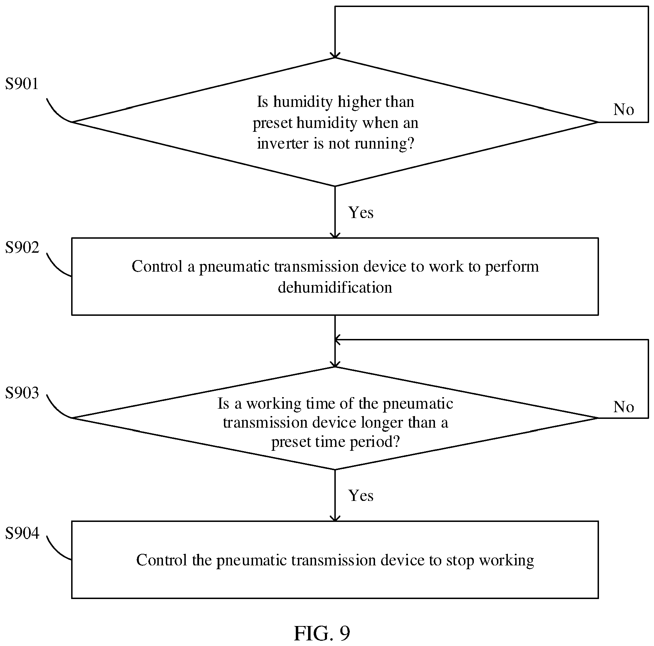

FIG. 9 is a flowchart of a humidity-based dehumidification method when an inverter is not running according to this embodiment of this application.

S901: When the inverter is not running, determine whether the humidity in the cabinet compartment is higher than the preset humidity; and if yes, perform S902; otherwise, continue to perform S901.

S902: Control the pneumatic transmission device to work.

S903: Determine whether the working time of the pneumatic transmission device is longer than a preset time period; and if yes, perform S904; otherwise, continue to perform S903.

S904: Control the pneumatic transmission device to stop working.

Generally, a photovoltaic array does not output a direct current at night when there is no sunlight, or the photovoltaic array outputs a small amount of direct current in cloudy and rainy days. In these cases, the inverter may not work. However, when the inverter does not work, the inverter may still be located in a high-humidity environment, and the high-humidity environment is prone to affect the inverter. Therefore, dehumidification also needs to be performed inside the inverter to protect the inverter.

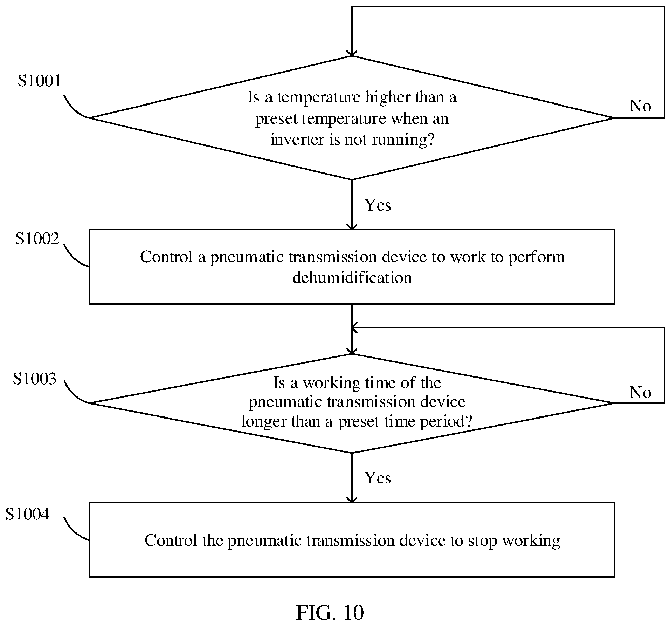

FIG. 10 is a flowchart of a temperature-based dehumidification method when an inverter is not running according to this embodiment of this application.

S1001: When the inverter is not running, determine whether the temperature in the cabinet compartment is higher than the preset temperature; and if yes, perform S 1002; otherwise, continue to perform S1001.

S1002: Control the pneumatic transmission device to work.

S 1003: Determine whether the working time of the pneumatic transmission device is longer than a preset time period; and if yes, perform S 1004; otherwise, continue to perform S 1003.

S 1004: Control the pneumatic transmission device to stop working.

Generally, a temperature and humidity are closely related. When the temperature rises, the humidity generally rises accordingly. Therefore, whether to trigger the pneumatic transmission device to work may also be determined based on the temperature.

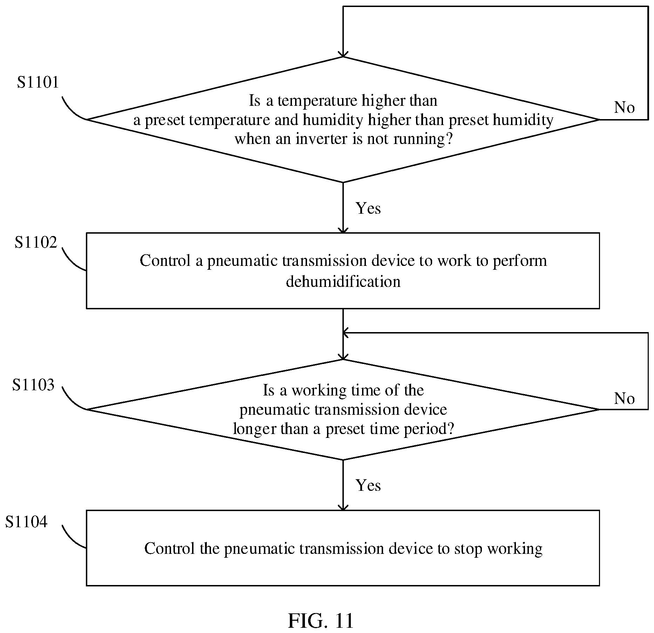

FIG. 11 is a flowchart of a humidity- and temperature-based dehumidification method when an inverter is not running according to this embodiment of this application.

S 1101: When the inverter is not running, determine whether the temperature in the cabinet compartment is higher than the preset temperature; and if yes, perform S1102; otherwise, continue to perform S1101.

S1102: Control the pneumatic transmission device to work.

S1103: Determine whether the working time of the pneumatic transmission device is longer than a preset time period; and if yes, perform S1104; otherwise, continue to perform S1103.

S1104: Control the pneumatic transmission device to stop working.

Specifically, a temperature and humidity sensor may be set in the cabinet compartment. The temperature and humidity sensor can measure both a temperature in the cabinet compartment and humidity in the cabinet compartment, and send the measured humidity and temperature to a controller. When determining that the temperature is higher than the preset temperature and the humidity is higher than the preset humidity, the controller starts a fan to work. The fan is controlled to stop working only when the humidity is less than or equal to the preset humidity and the temperature is less than or equal to the preset temperature.

In specific application, the dehumidification method for an inverter may use any method procedure in FIG. 5 to FIG. 11. This is not specifically limited in this embodiment of this application, provided that dehumidification is performed in the cabinet compartment of the inverter by using the pneumatic transmission device to blow the air in the cabinet compartment of the inverter to the breathable film of the ventilation valve.

It should be understood that in this application, "at least one (item)" refers to one or more and "a plurality of" refers to two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate a, b, c, a and b, a and c, b and c, or a and b and c, where a, b, and c may be singular or plural.

In summary, the foregoing embodiments are merely intended for describing the technical solutions of this application other than limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. An inverter, comprising a ventilation valve and a pneumatic transmission device, wherein:
the ventilation valve is installed on a surface of a cabinet compartment of the inverter, and the pneumatic transmission device is located in the cabinet compartment;
a breathable film is disposed on the ventilation valve; and
the pneumatic transmission device is configured to blow air in the cabinet compartment toward the breathable film when the following at least one preset condition is met, so that the air in the cabinet compartment flows out of the cabinet compartment through the breathable film, wherein
the at least one preset condition comprises at least one of or more of the following cases: the inverter is running, humidity in the cabinet compartment is higher than preset humidity, and a temperature in the cabinet compartment is higher than a preset temperature.

2. The inverter according to claim 1, further comprising a controller, wherein:
the controller is configured to: when the at least one preset condition is met, control the pneumatic transmission device to work, so that the air in the cabinet compartment flows out of the cabinet compartment through the breathable film; and
the pneumatic transmission device is configured to blow the air in the cabinet compartment toward the breathable film in a direction perpendicular to a plane of the breathable film.

3. The inverter according to claim 1 or 2, wherein the pneumatic transmission device is a fan or a pneumatic pump.

4. The inverter according to claim 3, wherein the controller is further configured to: when a working time of the pneumatic transmission device is longer than a preset time period, control the pneumatic transmission device to stop working.

5. The inverter according to any one of claims 2 to 4, wherein the controller is specifically configured to: when the inverter is running and the humidity in the cabinet compartment is higher than the preset humidity, control the pneumatic transmission device to work.

6. The inverter according to any one of claims 2 to 4, wherein the controller is specifically configured to: when the inverter is running and the temperature in the cabinet compartment is higher than the preset temperature, control the pneumatic transmission device to work.

7. The inverter according to any one of claims 2 to 4, wherein the controller is specifically configured to: when the inverter is running, the temperature in the cabinet compartment is higher than the preset temperature, and the humidity in the cabinet is higher than the preset humidity, control the pneumatic transmission device to work.

8. The inverter according to any one of claims 2 to 4, wherein the controller is specifically configured to: when the inverter is not running and the humidity in the cabinet compartment is higher than the preset humidity, control the pneumatic transmission device to work.

9. The inverter according to any one of claims 2 to 4, wherein the controller is specifically configured to: when the inverter is not running and the temperature in the cabinet compartment is higher than the preset temperature, control the pneumatic transmission device to work.

10. The inverter according to any one of claims 2 to 4, wherein the controller is specifically configured to:
when the inverter is not running, the temperature in the compartment is higher than the preset temperature, and the humidity in the compartment is higher than the preset humidity, control the pneumatic transmission device to work.

11. The inverter according to any one of claims 2 to 4, wherein the controller is specifically configured to:
when the inverter is running, control the pneumatic transmission device to work.

12. A photovoltaic power generation system, comprising the inverter according to any one of claims 1 to 11, and further comprising a photovoltaic array, wherein:
an input end of the inverter is connected to the photovoltaic array; and
the inverter is configured to convert a direct current of the photovoltaic array into an alternating current for output.

13. A dehumidification method for an inverter, wherein the inverter comprises a ventilation valve and a pneumatic transmission device, the ventilation valve is installed on a surface of a cabinet compartment of the inverter, the pneumatic transmission device is located in the cabinet compartment, and a breathable film is disposed on the ventilation valve; and
the method comprises:
when the following at least one preset condition is met, controlling the pneumatic transmission device to blow air in the cabinet compartment toward the breathable film, so that the air in the cabinet compartment flows out of the cabinet compartment through the breathable film, wherein
the at least one preset condition comprises at least one of or more of the following cases: the inverter is running, humidity in the cabinet compartment is higher than preset humidity, and a temperature in the cabinet compartment is higher than a preset temperature.

14. The method according to claim 13, wherein the blowing air in the cabinet compartment toward the breathable film specifically comprises:
blowing the air in the cabinet compartment toward the breathable film in a direction perpendicular to a plane of the breathable film.

15. The method according to claim 13, wherein the pneumatic transmission device is a fan or a pneumatic pump, and the method further comprises:
when a working time of the pneumatic transmission device is longer than a preset time period, controlling the pneumatic transmission device to stop working.

16. The method according to any one of claims 13 to 15, wherein controlling the pneumatic transmission device to work specifically comprises:
when the inverter is running and the humidity in the cabinet compartment is higher than the preset humidity, controlling the pneumatic transmission device to work.

17. The method according to any one of claims 13 to 15, wherein controlling the pneumatic transmission device to work specifically comprises:
when the inverter is running and the temperature in the cabinet compartment is higher than the preset temperature, controlling the pneumatic transmission device to work.

18. The method according to any one of claims 13 to 15, wherein controlling the pneumatic transmission device to work specifically comprises:
when the inverter is running, the temperature in the cabinet compartment is higher than the preset temperature, and the humidity in the cabinet is higher than the preset humidity, controlling the pneumatic transmission device to work.

19. The method according to any one of claims 13 to 15, wherein controlling the pneumatic transmission device to work specifically comprises:
when the inverter is not running and the humidity in the cabinet compartment is higher than the preset humidity, controlling the pneumatic transmission device to work.

20. The method according to any one of claims 13 to 15, wherein controlling the pneumatic transmission device to work specifically comprises:
when the inverter is not running and the temperature in the cabinet compartment is higher than the preset temperature, controlling the pneumatic transmission device to work.

21. The method according to any one of claims 13 to 15, wherein controlling the pneumatic transmission device to work specifically comprises:
when the inverter is not running, the temperature in the compartment is higher than the preset temperature, and the humidity in the compartment is higher than the preset humidity, controlling the pneumatic transmission device to work.

22. The method according to any one of claims 13 to 15, wherein controlling the pneumatic transmission device to work specifically comprises:
when the inverter is running, controlling the pneumatic transmission device to work.
